# EUROPÄISCHE PATENTSCHRIFT

(11) **EP 1 963 459 B1**
(45) Veröffentlichungstag und Bekanntmachung des Hinweises auf die Patenterteilung: **05.08.2009**
(21) Anmeldenummer: 06829068.3
(22) Anmeldetag: 17.11.2006
(51) Int. Cl.: C09K 11/06, H01L 51/00, C07C 13/00, C07C 15/00, C07C 25/00, C07C 22/00, C07C 43/00, C07C 211/00

(54) **ORGANISCHE ELEKTROLUMINESZENZVORRICHTUNGEN**
ORGANIC ELECTROLUMINESCENT DEVICES
DISPOSITIFS ORGANIQUES ÉLECTROLUMINESCENTS

(30) Priorität: 08.12.2005 DE 102005058558
(43) Veröffentlichungstag der Anmeldung: 03.09.2008
(73) Patentinhaber: Merck Patent GmbH, 64293 Darmstadt (DE)
(72) Erfinder: VESTWEBER, Horst, 34630 Gilersberg-Winterscheid (DE); HEIL, Holger, 64295 Darmstadt (DE); BREUNING, Esther, 65527 Niedernhausen (DE); PARHAM, Amir, 65929 Frankfurt (DE)
(86) Internationale Anmeldenummer: PCT/EP2006/011027
(87) Internationale Veröffentlichungsnummer: WO 2007/065548

(56) Entgegenhaltungen:
- EP-A- 1 553 154
- EP-A1- 0 866 110
- EP-A1- 1 061 112
- WO-A-20/05100507
- WO-A2-20/04058911
- US-A1- 2004 202 891
- US-A1- 2005 112 404
- C.H. CHEN ET.AL.: "Stable styrylamine-doped blue organic electroluminescent device based on 2-methyl-9,10-di(2-naphtyl)anthracene" APPLIED PHYSICS LETTERS, Bd. 85, Nr. 15, 2004, Seiten 3301-3303, XP002416926
- C. H. CHEN ET.AL.: "Highly efficient, deep-blue doped organic light-emitting devices" ADV. MATER., Bd. 17, Oktober 2005 (2005-10), Seiten 2493-2497, XP002416912

## Beschreibung

Die vorliegende Erfindung betrifft Mischungen organischer Materialien, die Verwendung dieser Mischungen in organischen Elektrolumineszenzvorrichtungen und organische Elektrolumineszenzvorrichtungen enthaltend diese Mischungen.

Der allgemeine Aufbau organischer Elektrolumineszenzvorrichtungen, die zur Emission von Licht im sichtbaren Spektralbereich befähigt sind und halbleitende organische Verbindungen enthalten, ist beispielsweise in US 4539507, US 5151629, EP 0676461 und WO 98/27136 beschrieben.

Allerdings zeigen diese Vorrichtungen immer noch erhebliche Probleme, die für die Verwendung in hochwertigen Vollfarbdisplays einer dringenden Verbesserung bedürfen. So ist die operative Lebensdauer insbesondere bei blauer Emission immer noch nicht ausreichend, so dass bis dato nur einfache Anwendungen kommerziell realisiert werden konnten. Für hochwertige Vollfarbdisplays sind hier weitere Verbesserungen nötig.

In JP 08-239655 werden verschiedene Styrylamine, die jeweils mindestens eine Stilbengruppe und mindestens zwei Arylaminogruppen enthalten, als blaue Emitter beschrieben. Es werden jedoch keine geeigneten Hostmaterialien für diese Verbindungen angegeben.

In EP 1167488 wird allgemein die Kombination von Monostyrylaminen, Distyrylaminen, Tristyrylaminen bzw. Tetrastyrylaminen zusammen mit bestimmten Dianthracenderivaten bzw. mit Anthracenderivaten, welche mit kondensierten Aromaten oder mit Arylgruppen mit 12 oder mehr Kohlenstoffatomen substituiert sind, vorgeschlagen. Als bevorzugte Emitter werden lineare Styrylamine ausgeführt. Ebenso wurden die weiteren Entwicklungen für diese Styrylamine optimiert (z. B. WO 04/013073, WO 04/016575, WO 04/018587). Diese Styrylamine gehören zu den besten blau emittierenden Materialien, die derzeit auf dem Markt sind. Gerade für diese Materialien sind noch weitere Verbesserungen an geeigneten Hostmaterialien wünschenswert, um die Eigenschaften, insbesondere die Lebensdauer, noch weiter zu verbessern.

In WO 05/061656 werden unsymmetrisch substituierte Anthracenderivate als Host für lineare Stilbenamine beschrieben. Diese Verbindungen haben den deutlichen technischen Nachteil, dass sie im Gegensatz zu symmetrisch substituierten Verbindungen nur aufwändig in mehreren Syntheseschritten herzustellen sind.

C.H. CHEN ET.AL. offenbart in "Stable styrylamine-doped blue organic electroluminescent device based on 2-methyl-9,10-di(2-naphtyl)anthracene" [APPLIED PHYSICS LETTERS, Bd. 85, Nr. 15, 2004, Seiten 3301-3303, XP002416926] organische Elektrolumineszenzvorrichtungen mit Anode, Kathode und einer elektrolumineszenten Schicht, bestehend aus einer Mischung aus 2-Methyl-9,10-di(2-naphtyl)anthracene (MADN) und p-bis(p-N,N-diphenyl-aminostyryl)benzen (DSA-Ph).

Es war daher Aufgabe der vorliegenden Erfindung, hierfür Verbesserungen anzubieten, insbesondere Hostmaterialien, die mit diesen Styrylaminen zu einer Verbesserung der Lebensdauer führen.

Überraschend wurde gefunden, dass organische Elektrolumineszenzvorrichtungen, die eine Kombination aus bestimmten Styrylaminen und 9,10-Bis(1-naphthyl)anthracen und Derivaten davon in der emittierenden Schicht enthalten, deutliche Verbesserungen gegenüber dem Stand der Technik aufweisen, insbesondere eine deutlich verbesserte Lebensdauer. Dieses Ergebnis ist insbesondere daher überraschend, da aus dem oben genannten Stand der Technik ähnliche Hostmaterialien in Kombination mit Styrylaminen bekannt sind, die jedoch eine schlechtere Lebensdauer zeigen. Dass diese Hostmaterialien in dieser Kombination einen solchen Einfluss auf die Lebensdauer der Vorrichtungen haben, ist daher ein unerwartetes und nicht vorhersehbares Ergebnis. Diese Materialmischungen und deren Verwendung in OLEDs sind daher der Gegenstand der vorliegenden Erfindung.

Gegenstand der Erfindung sind organische Elektrolumineszenzvorrichtungen, enthaltend Anode, Kathode und mindestens eine organische Schicht, dadurch gekennzeichnet, dass die organische Schicht die folgenden Komponenten enthält:
a) mindestens eine Verbindung der Formel (1), 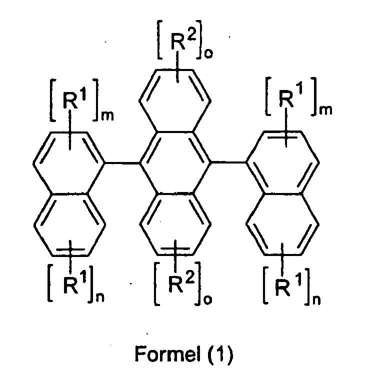 wobei für die verwendeten Symbole gilt
   - R¹: ist gleich oder verschieden bei jedem Auftreten F, Cl, Br, I, CN, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch -R³C=CR³-, -C≡C-, Si(R³)₂, Ge(R³)₂, Sn(R³)₂, C=O, C=S, C=Se, C=NR², -O-, -S-, -N(R³)- oder -CONR³- ersetzt sein können und wobei ein oder mehrere H-Atome durch F, Cl, Br, I, CN oder NO₂ ersetzt sein können, oder eine Aralkylgruppe mit 7 bis 30 C-Atomen, die mit einem oder mehreren Resten R³ substituiert sein kann, oder eine Aryloxy- oder Heteroaryloxy- gruppe mit 5 bis 24 aromatischen Ringatomen, die durch einen oder mehrere nicht-aromatische Reste R³ substituiert sein kann; dabei können auch zwei oder mehrere Substituenten R¹ miteinander ein mono- oder polycyclisches, aliphatisches Ringsystem bilden;
   - R²: ist bei jedem Auftreten gleich oder verschieden R¹ oder ein aromatisches oder heteroaromatisches Ringsystem mit 5 bis 30 aromatischen Ringatomen, welches mit einem oder mehreren Resten R³ substituiert sein kann;
   - R³: ist bei jedem Auftreten gleich oder verschieden H oder ein aliphatischer oder aromatischer Kohlenwasserstoffrest mit 1 bis 20 C-Atomen; dabei können auch zwei oder mehrere Reste R³ miteinander ein mono- oder polycyclisches, aliphatisches oder aromatisches Ringsystem bilden;
   - m: ist gleich oder verschieden bei jedem Auftreten 0, 1, 2 oder 3;
   - n, o: ist gleich oder verschieden bei jedem Auftreten 0, 1, 2, 3 oder 4;
   und
b) mindestens eine Verbindung der Formel (2), 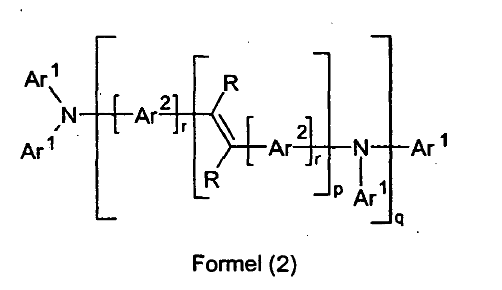 wobei für die verwendeten Symbole gilt:
   - Ar¹: ist gleich oder verschieden bei jedem Auftreten ein aromatisches oder heteroaromatisches Ringsystem mit 5 bis 30 aromatischen Ringatomen, welches durch einen oder mehrere Reste R⁴ substituiert sein kann;
   - Ar²: ist gleich oder verschieden bei jedem Auftreten eine Arylen- oder Heteroarylengruppe mit 5 bis 20 aromatischen Ring- atomen, welche durch einen oder mehrere Reste R⁴ substituiert sein kann;
   - R: ist gleich oder verschieden bei jedem Auftreten H, F, CN, eine geradkettige Alkylgruppe mit 1 bis 40 C-Atomen oder eine verzweigte oder cyclische Alkylkette mit 3 bis 40 C-Atomen, die jeweils mit einem oder mehreren Resten R⁵ substituiert sein kann, wobei eine oder mehrere nicht benachbarte CH₂-Gruppen, die nicht direkt an die Doppelbindung binden, durch -R⁵C=CR⁵-, -C≡C-, Si(R⁵)₂, Ge(R⁵)₂, Sn(R⁵)₂, C=O, C=S, C=Se, C=NR⁵, -O-, -S-, -N(R⁵)- oder -CONR⁵- ersetzt sein können und wobei ein oder mehrere H-Atome durch F, Cl, Br, I, CN oder NO₂ ersetzt sein können, oder eine Aryl- oder Hetero- arylgruppe mit 5 bis 30 aromatischen Ringatomen, die wiederum mit einem oder mehreren Resten R⁵ oder mit einer Diphenylaminogruppe, wobei die Phenylgruppen durch nicht- aromatische Reste R substituiert sein können, substituiert sein kann;
   - R⁴: ist gleich oder verschieden bei jedem Auftreten H, F, Cl, Br, I, CN, Si(R⁵)₃, N(R⁵)₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R⁵ substituiert sein kann, wobei eine oder mehrere nicht benachbarte CH₂-Gruppen durch -R⁵C=CR⁵-, -C≡C-, Si(R⁵)₂, Ge(R⁵)₂, Sn(R⁵)₂, C=O, C=S, C=Se, C=NR⁵, -O-, -S-, -N(R⁵)- oder -CONR⁵- ersetzt sein können und wobei ein oder mehrere H-Atome durch F, Cl, Br, I, CN oder NO₂ ersetzt sein können, oder eine Aryl- oder Heteroarylgruppe mit 5 bis 30 aromatischen Ringatomen, die mit einem oder mehreren nicht-aromatischen Resten R⁵ substituiert sein kann, oder eine Aryloxy- oder Heteroaryloxygruppe mit 5 bis 24 aromatischen Ringatomen, die durch einen oder mehrere nicht-aromatische Reste R⁴ substituiert sein kann; dabei können auch zwei oder mehrere Substituenten R⁴ miteinander, auch an verschiedenen Gruppen Ar¹ bzw. Ar², ein mono- oder polycyclisches, aliphatisches oder aromatisches Ringsystem bilden;
   - R⁵: ist bei jedem Auftreten gleich oder verschieden H oder ein aliphatischer oder aromatischer Kohlenwasserstoffrest mit 1 bis 20 C-Atomen; dabei können auch zwei oder mehrere Reste R⁵ miteinander ein mono- oder polycyclisches, aliphatisches oder aromatisches Ringsystem bilden;
   - p, r: ist gleich oder verschieden bei jedem Auftreten 1, 2 oder 3;
   - q ist: 1, 2 oder 3;

Die organische Schicht ist zur Emission von Licht befähigt und ist bevorzugt eine emittierende Schicht.

Unter einer Arylgruppe bzw. einer Heteroarylgruppe im Sinne dieser Erfindung wird eine monovalente aromatische Gruppe bzw. eine monovalente heteroaromatische Gruppe mit einem gemeinsamen aromatischen π-Elektronensystem verstanden. Unter einer Arylengruppe bzw. Heteroarylengruppe im Sinne dieser Erfindung wird eine entsprechende bivalente Gruppe verstanden. Dies kann im Sinne dieser Erfindung ein einfacher Homo- oder Heterocyclus sein, beispielsweise Benzol, Pyridin, Thiophen, etc., oder es kann ein kondensiertes aromatisches Ringsystem sein, in dem mindestens zwei aromatische oder heteroaromatische Ringe, beispielsweise Benzolringe, miteinander "verschmolzen", d. h. durch Anellierung einander ankondensiert sind, also mindestens eine gemeinsame Kante und dadurch auch ein gemeinsames aromatisches π-Elektronensystem aufweisen. Diese Aryl- oder Heteroarylgruppen können substituiert oder unsubstituiert sein; ebenso können gegebenenfalls vorhandene Substituenten weitere Ringsysteme bilden. So sind beispielsweise Systeme wie Naphthalin, Anthracen, Phenanthren, Pyren, etc. als Arylgruppen und Chinolin, Acridin, Benzothiophen, Carbazol, etc. als Heteroarylgruppen im Sinne dieser Erfindung zu sehen, während beispielsweise Biphenyl, Fluoren, Spirobifluoren, etc. keine Arylgruppen darstellen, da es sich hierbei um separate aromatische Elektronensysteme handelt.

Ein aromatisches Ringsystem im Sinne dieser Erfindung enthält 6 bis 30 C-Atome im Ringsystem. Ein heteroaromatisches Ringsystem im Sinne dieser Erfindung enthält 2 bis 30 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine kurze, nicht-aromatische Einheit (weniger als 10 % der von H verschiedenen Atome, bevorzugt weniger als 5 % der von H verschiedenen Atome), wie z. B. ein sp³-hybridisiertes C-, N- oder O-Atom, unterbrochen sein können. So sollen beispielsweise auch Systeme wie 9,9'-Spirobifluoren, 9,9-Diarylfluoren, Stilben, Triarylamin, Diarylether, etc. als aromatische Ringsysteme im Sinne dieser Erfindung verstanden werden. Dabei kann ein Teil des aromatischen oder heteroaromatischen Ringsystems auch eine kondensierte Gruppe sein.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 1 bis 30 aromatischen Ringatomen, welches noch jeweils mit den oben genannten Resten R¹ bzw. R² substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Tetracen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Im Folgenden werden bevorzugte Ausführungsformen für Verbindungen der Formel (1) beschrieben.

Bevorzugt sind weiterhin Verbindungen gemäß Formel (1), in denen das Symbol R¹, gleich oder verschieden bei jedem Auftreten, für F, eine geradkettige Alkyl- oder Alkoxygruppe mit 1 bis 6 C-Atomen oder eine verzweigte oder cyclische Alkyl- oder Alkoxygruppe mit 3 bis 10 C-Atomen, wobei jeweils ein oder mehrere CH₂-Gruppen durch -R³C=CR³-, Si(R³)₂, -O-, -S- oder -N(R³)- ersetzt sein können und wobei jeweils ein oder mehrere H-Atome durch F ersetzt sein können steht; dabei können auch zwei oder mehrere Reste R¹ miteinander ein mono- oder polycyclisches, aliphatisches Ringsystem bilden. Besonders bevorzugte Reste R¹ sind ausgewählt aus der Gruppe bestehend aus F, geradkettigen Alkylgruppen mit 1 bis 4 C-Atomen, verzweigten Alkylgruppen mit 3 bis 5 C-Atomen oder cyclischen Alkygruppen mit 5 bis 10 C-Atomen, wobei jeweils ein oder mehrere H-Atome durch F ersetzt sein können; dabei können auch zwei oder mehrere benachbarte Reste R¹ miteinander ein mono- oder polycyclisches, aliphatisches Ringsystem bilden.

Bevorzugt sind weiterhin Verbindungen gemäß Formel (1), in denen das Symbol R² für ein aromatisches oder heteroaromatisches Ringsystem mit 5 bis 16 aromatischen Ringatomen, welches durch einen oder mehrere Reste R³ substituiert sein kann, steht, besonders bevorzugt für ein aromatisches oder heteroaromatisches Ringsystem mit 6 bis 14 aromatischen Ringatomen, welches durch einen oder mehrere Reste R³ substituiert sein kann.

Bevorzugt sind weiterhin Verbindungen gemäß Formel (1), in denen der Index m für 0, 1 oder 2 steht, besonders bevorzugt für 0 oder 1. Falls der Index m für 1 steht, ist der Substituent R¹ bevorzugt in 4-Position des Naphthyls gebunden.

Bevorzugt sind weiterhin Verbindungen gemäß Formel (1), in denen der Index n für 0, 1 oder 2 steht, besonders bevorzugt für 0 oder 1, ganz besonders bevorzugt für 0.

Bevorzugt sind weiterhin Verbindungen gemäß Formel (1), in denen der Index o für 0, 1 oder 2 steht, besonders bevorzugt für 0 oder 1, ganz besonders bevorzugt für 0. Falls der Index o für 1 steht, ist der Substituent R¹ bevorzugt in 2-Position bzw. in 6-Position des Anthracens gebunden.

Bevorzugt sind weiterhin Verbindungen gemäß Formel (1), deren Molekulargewicht zwischen 430 und 1200 glmol liegt, besonders bevorzugt zwischen 430 und 900 g/mol.

Die beiden Naphthylgruppen können gleich oder verschieden substituiert sein. Bevorzugt sind die beiden Naphthylgruppen gleich substituiert, so dass die Verbindungen gemäß Formel (1) symmetrisch bezüglich der Substituenten an den Naphthylgruppen sind.

Bevorzugt sind die Verbindungen gemäß Formel (1) reine Kohlenwasserstoffverbindungen.

Die Verbindungen der Formel (1) zeigen Atropisomerie um die Naphthyl-Anthracen-Bindungen. Es sind sowohl OLEDs enthaltend die Mischung der Atropisomeren wie auch OLEDs enthaltend die isolierten oder angereicherten Atropisomere Gegenstand der Erfindung. Dies bezieht sich sowohl auf Enantiomere wie auch auf Diastereomere. Durch die Wahl geeigneter Atropisomere lassen sich beispielsweise die Löslichkeit der Verbindung und die elektrooptischen Eigenschaften beeinflussen. Dies ist beispielsweise in WO 06/048268 beschrieben.

Beispiele für bevorzugte Verbindungen gemäß Formel (1) sind die im Folgenden abgebildeten Verbindungen (H1) bis (H20).

| | |
|---|---|
| 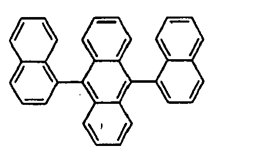 | 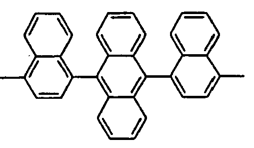 |
| (H1) | (H2) |
| 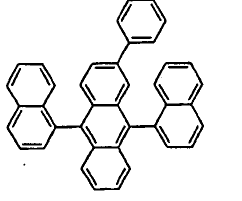 | 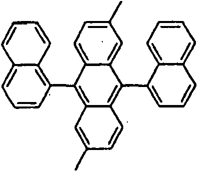 |
| (H3) | (H4) |
| 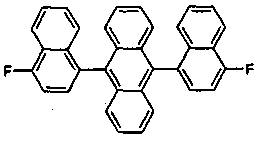 | 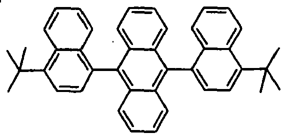 |
| (H5) | (H6) |
| 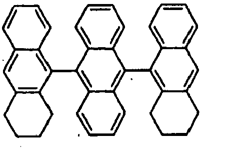 | 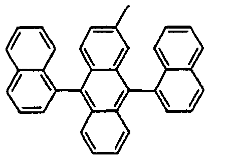 |
| (H7) | (H8) |
| 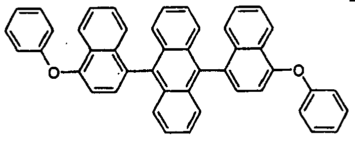 | 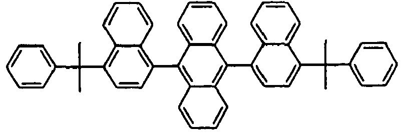 |
| (H9) | (H10) |
| 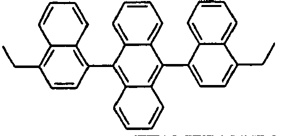 | 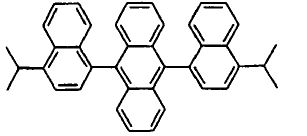 |
| (H11) | (H12) |
| 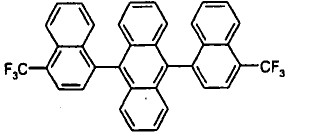 | 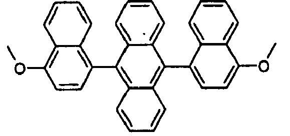 |
| (H13) | (H14) |
| 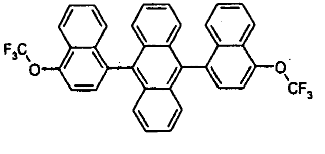 | 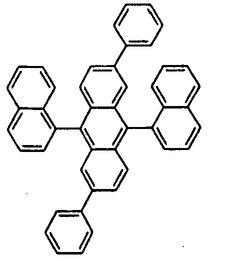 |
| (H15) | (H16) |
| 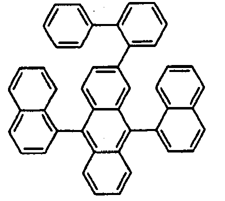 | 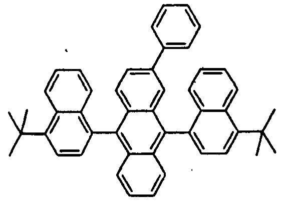 |
| (H17) | (H18) |
| 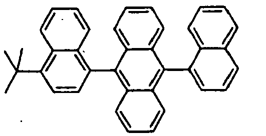 | 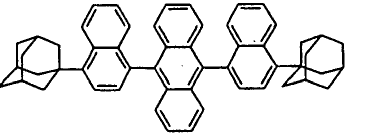 |
| (H19) | (H20) |

Im Folgenden werden bevorzugte Ausführungsformen für Verbindungen der Formel (2) beschrieben.

Bevorzugt sind Verbindungen gemäß Formel (2), in denen das Symbol Ar¹, gleich oder verschieden bei jedem Auftreten, für eine Aryl-, Biaryl- oder Heteroarylgruppe, insbesondere eine Aryl- oder Biarylgruppe, mit 6 bis 14 C-Atomen steht, welche durch einen oder mehrere Reste R⁴ substituiert sein kann, besonders bevorzugt für eine Phenyl-, Biphenyl- oder Naphthylgruppe, die jeweils durch einen oder mehrere Reste R⁴ substituiert sein kann, ganz besonders bevorzugt für eine Phenylgruppe, die durch einen oder mehrere Reste R⁴ substituiert sein kann. Bevorzugt sind weiterhin Verbindungen gemäß Formel (2), in denen das Symbol Ar², gleich oder verschieden bei jedem Auftreten, für eine Arylen- oder Heteroarylengruppe, insbesondere eine Arylengruppe, mit 5 bis 14 aromatischen Ringatomen, besonders bevorzugt mit 6 bis 10 aromatischen Ringatomen steht, welche mit einem oder mehreren Resten R⁴ substituiert sein kann, ganz besonders bevorzugt für eine Phenylen- oder Naphthylengruppe, die jeweils durch einen oder mehrere Reste R⁴ substituiert sein kann, insbesondere für eine Phenylengruppe, die durch einen oder mehrere Reste R⁴ substituiert sein kann.

Bevorzugte Reste R sind Wasserstoff, eine geradkettige Alkylgruppe mit 1 bis 4 C-Atomen, eine verzweigte oder cyclische Alkylgruppe mit 3 bis 5 C-Atomen oder eine Phenyl- bzw. Naphthylgruppe, welche auch durch einen oder mehrere Reste R⁵ substituiert sein kann. Besonders bevorzugt ist der Rest R gleich Wasserstoff.

Besonders bevorzugt sind also Verbindungen der folgenden Formel (2a), wobei die Phenyl- bzw. Phenylengruppen noch durch einen oder mehrere Reste R⁴ substituiert sein können:

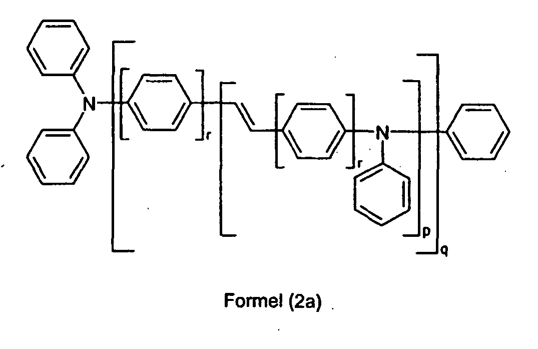

Bevorzugte Reste R⁴ sind ausgewählt aus der Gruppe bestehend aus H, F, geradkettigen Alkyl- oder Alkoxygruppen mit 1 bis 6 C-Atomen oder verzweigten oder cyclischen Alkyl- oder Alkoxygruppen mit 3 bis 10 C-Atomen, die mit einem oder mehreren Resten R⁵ substituiert sein können und wobei jeweils ein oder mehrere CH₂-Gruppen durch -R⁵C=CR⁵-, Si(R⁵)₂, -O-, -S- oder -N(R⁵)-ersetzt sein können und wobei jeweils ein oder mehrere H-Atome durch F ersetzt sein können, oder monovalenten Aryl- oder Heteroarylgruppen mit 5 bis 14 aromatischen Ringatomen; dabei können zwei oder mehrere Reste R⁴ auch miteinander ein Ringsystem bilden. Besonders bevorzugte Reste R⁴ sind ausgewählt aus der Gruppe bestehend aus H, F, geradkettigen Alkylgruppen mit 1 bis 4 C-Atomen, verzweigten Alkylgruppen mit 3 bis 5 C-Atomen oder cyclischen Alkygruppen mit 5 bis 10 C-Atomen, die jeweils durch einen oder mehrere Reste R⁵ substituiert sein können und wobei jeweils ein oder mehrere H-Atome durch F ersetzt sein können, oder monovalenten Aryl- oder Heteroarylgruppen mit 6 bis 10 aromatischen Ringatomen; dabei können zwei oder mehrere Reste R⁴ auch miteinander ein Ringsystem bilden. Ganz besonders bevorzugte Reste R³ sind ausgewählt aus H, F, Methyl, CF₃, Ethyl, iso-Propyl, *tert-*Butyl, Adamantyl, Methoxy, Trifluormethoxy, Phenyl, ortho-Tolyl, meta-Tolyl, para-Tolyl, para-Fluorphenyl und Si(CH₃)₃·

Beispiele für bevorzugte Verbindungen gemäß Formel (2) sind die im Folgenden abgebildeten Verbindungen (D1) bis (D20).

| | |
|---|---|
| 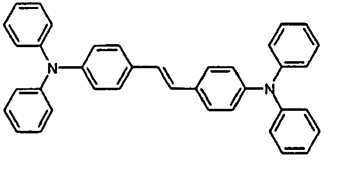 | 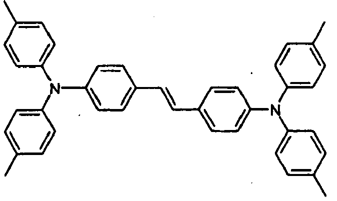 |
| (D1) | (D2) |
| 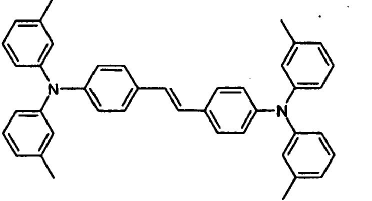 | 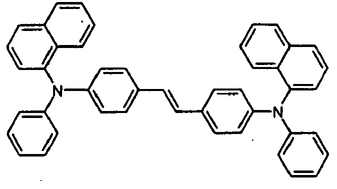 |
| (D3) | (D4) |
| 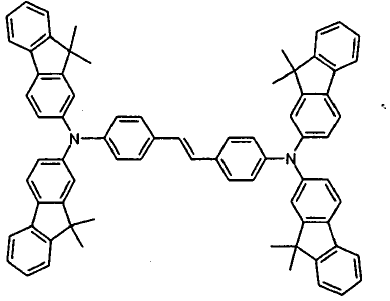 | 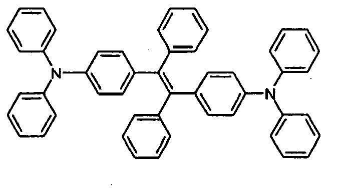 |
| (D5) | (D6) |
| 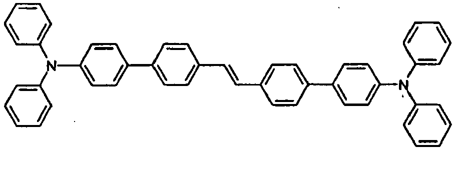 | 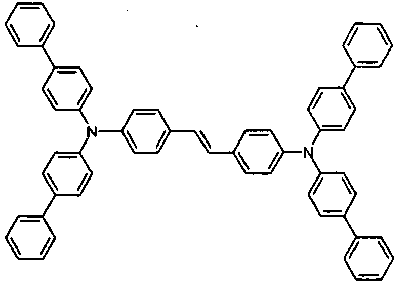 |
| (D7) | (D8) |
| 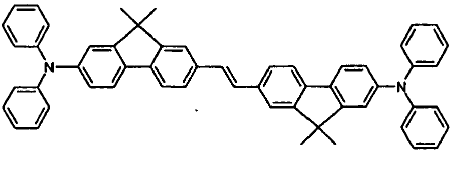 | 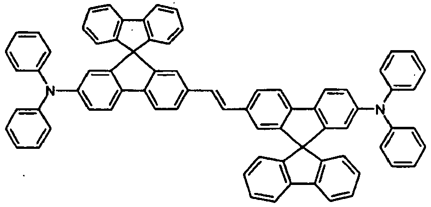 |
| (D9) | (D10) |
| 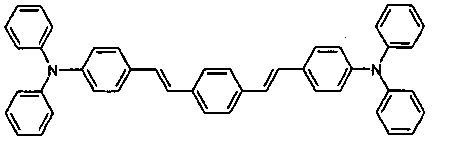 | 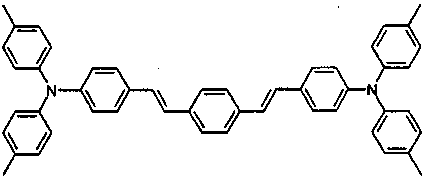 |
| (D11) | (D12) |
| 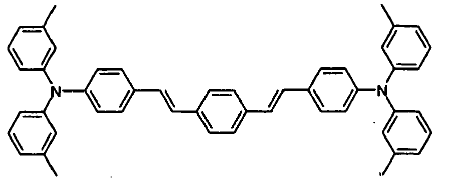 | 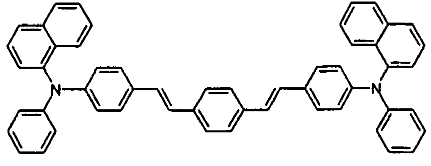 |
| (D13) | (D14) |
| 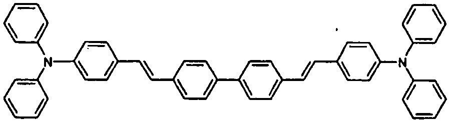 | 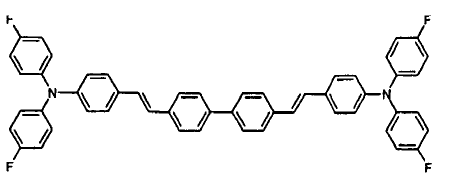 |
| (D15) | (D16) |
| 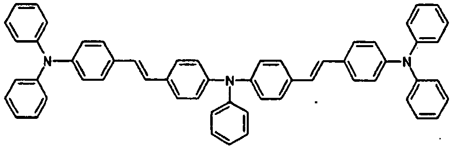 | 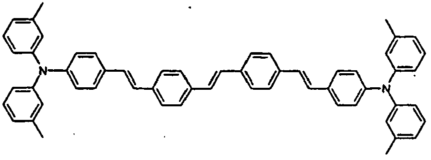 |
| (D17) | (D18) |
| 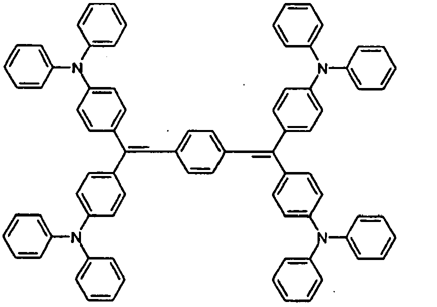 | 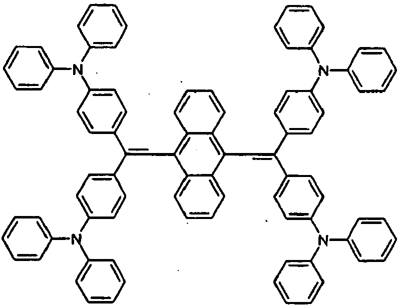 |
| (D19) | (D20) |

Der Anteil der Verbindung gemäß Formel (1) in der Mischung beträgt zwischen 1.0 und 99.9 Gew.-%, bevorzugt zwischen 50.0 und 99.5 Gew.-%, besonders bevorzugt zwischen 80.0 und 99.0 Gew.-%, insbesondere zwischen 90.0 und 99.0 Gew.-%.

Entsprechend beträgt der Anteil der Verbindung gemäß Formel (2) in der Mischung zwischen 0.1 und 99.0 Gew.-%, bevorzugt zwischen 0.5 und 50.0 Gew.-%, besonders bevorzugt zwischen 1.0 und 20.0 Gew.%, insbesondere zwischen 1.0 und 10.0 Gew.-%.

Weiterhin bevorzugt sind organische Elektrolumineszenzvorrichtungen, dadurch gekennzeichnet, dass mehrere emittierende Schichten verwendet werden, wobei mindestens eine dieser Schichten mindestens eine Verbindung gemäß Formel (1) und mindestens eine Verbindung gemäß Formel (2) enthält. Besonders bevorzugt weisen diese Emissionsschichten insgesamt mehrere Emissionsmaxima zwischen 380 nm und 750 nm auf, so dass insgesamt weiße Emission resultiert, d. h. in der bzw. den weiteren emittierenden Schichten wird noch mindestens eine weitere emittierende Verbindung verwendet, die fluoreszieren oder phosphoreszieren kann und die gelbes, orange oder rotes Licht emittiert. Insbesondere bevorzugt sind Dreischichtsysteme, wobei mindestens eine dieser Schichten mindestens eine Verbindung gemäß Formel (1) und eine Verbindung gemäß Formel (2) enthält und wobei die drei Schichten blaue, grüne und orange oder rote Emission zeigen (für den prinzipiellen Aufbau siehe z. B. WO 05/011013).

Außer den Verbindungen gemäß Formel (1) und Formel (2) können in der emittierenden Schicht auch weitere Substanzen vorhanden sein, beispielsweise Loch- oder Elektronentransportmaterialien.

Außer Kathode, Anode und der emittierenden Schicht (bzw. den emittierenden Schichten) kann die organische Elektrolumineszenzvorrichtung noch weitere Schichten enthalten. Diese können beispielsweise sein: Lochinjektionsschicht, Lochtransportschicht, Elektronentransportschicht und/oder Elektroneninjektionsschicht. Die Materialien in diesen Schichten können auch dotiert sein. Es muss aber nicht notwendigerweise jede dieser Schichten vorhanden sein muss. Als Lochtransportmaterialien eignen sich aromatische Amine; wie sie üblicherweise gemäß dem Stand der Technik verwendet werden, welche auch p-dotiert sein können. Als Elektronentransportmaterialien eignen sich beispielsweise Metallchelatkomplexe, z. B. AlQ₃, Verbindungen auf Basis elektronenarmer Heterocyclen, z. B. Triazinderivate, oder Verbindungen enthaltend aromatische Carbonyle oder Phosphinoxide, wie z. B. beschrieben in WO 05/084081 und WO 05/084082, welche jeweils auch n-dotiert sein können. Als Elektroneninjektionsmaterialien eignen sich insbesondere Fluoride und Oxide der Alkali- und Erdalkalimetalle, beispielsweise NaF, BaF₂, CaF₂, LiF oder Li₂O.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen gemäß Formel (1) und Formel (2) nötig. Hohe Löslichkeit lässt sich entweder durch geeignete Substitution der Verbindungen oder aber auch durch die Wahl geeigneter Atropisomere erreichen.

Ein weiterer Gegenstand der Erfindung ist ein Verfahren zur Herstellung von organischen Elektrolumineszenzvorrichtungen, dadurch gekennzeichnet, dass mindestens eine Verbindung gemäß Formel (1) zusammen mit mindestens einer Verbindung gemäß Formel (2) durch ein Sublimationsverfahren oder aus Lösung, beispielsweise durch ein Druckverfahren, aufgebracht werden.

Weiterer Gegenstand sind Mischungen enthaltend mindestens eine Verbindung gemäß Formel (1) und mindestens eine Verbindung gemäß Formel (2), wobei für die die Mischungen die oben ausgeführten Bevorzugungen ebenfalls zutreffen.

Weiterer Gegenstand der Erfindung ist die Verwendung der erfindungsgemäßen Mischungen zur Herstellung organischer elektronischer Vorrichtungen, insbesondere organischer Elektrolumineszenzvorrichtungen.

Die erfindungsgemäßen organischen Elektrolumineszenzvorrichtungen weisen eine höhere Stabilität auf im Vergleich zu Systemen gemäß dem Stand der Technik, in denen die Emitter gemäß Formel (2) in anderen Hostmaterialien verwendet wird, was sich vor allem in einer deutlich höheren Lebensdauer zeigt.

Im vorliegenden Anmeldetext und auch in den im Weiteren folgenden Beispielen wird auf die Verwendung erfindungsgemäßer Mischungen in Bezug auf OLEDs und die entsprechenden Displays abgezielt. Trotz dieser Beschränkung der Beschreibung ist es für den Fachmann ohne weiteres erfinderisches Zutun möglich, die erfindungsgemäßen Mischungen auch für weitere Verwendungen in anderen elektronischen Vorrichtungen zu benutzen, z. B. für organische Feld-Effekt-Transistoren (O-FETs), organische Dünnfilmtransistoren (O-TFTs), organische lichtemittierende Transistoren (O-LETs), organische integrierte Schaltungen (O-ICs), organische Solarzellen (O-SCs), organische Feld-Quench-Devices (O-FQDs), organische Photorezeptoren oder organische Laserdioden (O-Laser).

Die Verwendung der erfindungsgemäßen Mischungen in den entsprechenden Vorrichtungen ebenso wie diese Vorrichtungen selbst sind ein weiterer Gegenstand der vorliegenden Erfindung.

Die Erfindung wird durch die nachfolgenden Beispiele näher erläutert, ohne sie dadurch einschränken zu wollen.

### Beispiele:

### Beispiel 1: Herstellung der OLEDs

Die Herstellung von OLEDs erfolgt nach einem allgemeinen Verfahren gemäß WO 04/058911, das im Einzelfall auf die jeweiligen Gegebenheiten (z. B. Schichtdickenvariation, um optimale Effizienz bzw. Farbe zu erreichen) angepasst wird. Der grundlegende Aufbau und die verwendeten Materialien (außer der emittierenden Schicht) sind in den Beispielen zur besseren Vergleichbarkeit identisch. Analog dem o. g. allgemeinen Verfahren werden OLEDs mit folgendem Aufbau erzeugt:

| | |
|---|---|
| Lochinjektionsschicht (HIL) | 20 nm PEDOT (aus Wasser aufgeschleudert; bezogen von H. C. Starck, Goslar, Deutschland; Poly(3,4-ethylendioxy-2,5-thiophen)) |
| Lochtransportschicht (HTM) | 10 nm 2,2',7,7'-Tetrakis(di-para-tolyl-amino)spiro-9,9'-bifluoren (abgekürzt als **HTM-1)** |
| Lochtransportschicht (HTM) | 30 nm NPB (N-Naphthyl-N-phenyl-4,4'-diaminobiphenyl) |
| Emissionschicht (EML) | siehe Tabelle 1 für Materialien, Konzentration und Schichtdicke |
| Elektronenleiter (ETL) | 20 nm AlQ₃ (bezogen von SynTec, Tris(chinolinato)aluminium(III)) |
| Kathode | 1 nm LiF, darauf 150 nm Al. |

Diese OLEDs werden standardmäßig charakterisiert; hierfür werden die Elektrolumineszenzspektren, die Effizienz (gemessen in cd/A), die Leistungseffizienz (gemessen in Im/W) in Abhängigkeit der Helligkeit, berechnet aus Strom-Spannungs-Helligkeit-Kennlinien (IUL-Kennlinien), und die Lebensdauer bestimmt. Als Lebensdauer wird die Zeit definiert, nach der die Anfangshelligkeit von 1000 cd/m² auf die Hälfte gesunken ist.

In Tabelle 1 sind die Ergebnisse einiger OLEDs (Beispiele 2 bis 9) zusammengefasst, die den Dotanden **D1** enthalten, wobei jeweils die Zusammensetzung der EML inklusive der Schichtdicken mit aufgeführt ist. Die Struktur des Dotanden **D1** ist im Folgenden abgebildet:

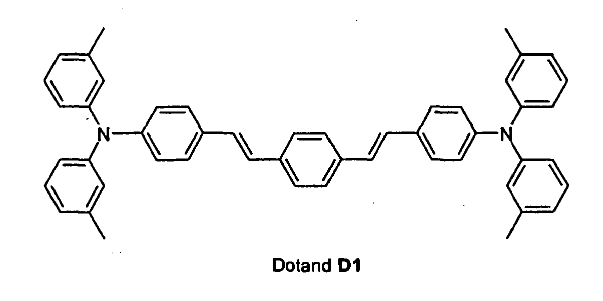

Als erfindungsgemäßes Hostmaterial wird 9,10-Bis(1-naphthyl)anthracen (**H1**) und 9,10-Bis(4-Methylnaphth-1-yl)anthracen (**H2,** synthetisiert gemäß WO 06/048268; schlechter lösliches Atropisomer mit einem Atropisomerenüberschuss von 99 %) eingesetzt. Als Hostmaterial gemäß dem Stand der Technik werden zum Vergleich die Hostmaterialien **H3** (9,10-Bis(2-spirobifluorenyl)anthracen), **H4** und **H5** eingesetzt. Die Hostmaterialien sind im Folgenden abgebildet:

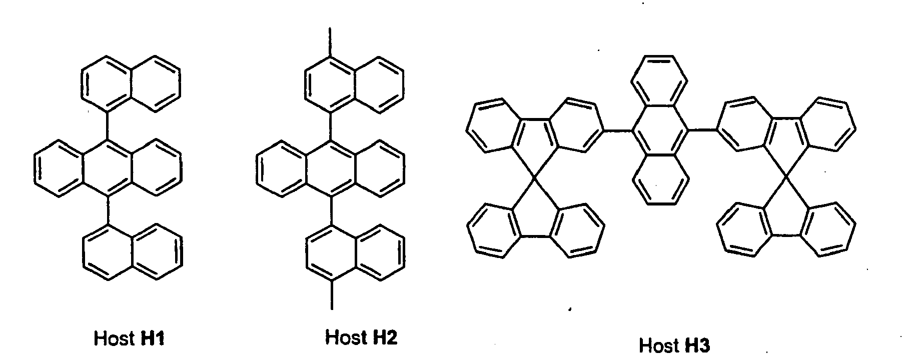

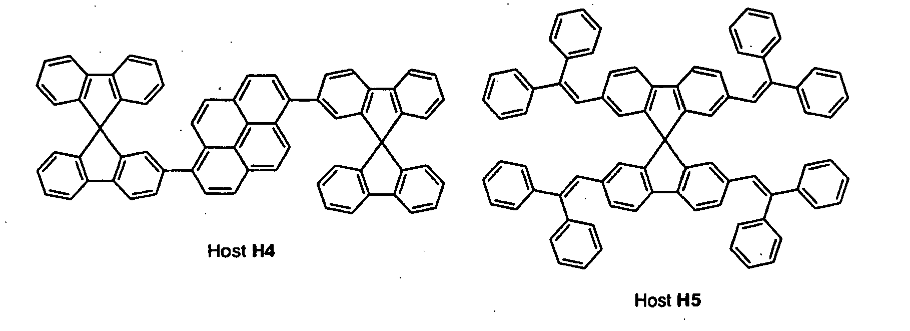

Wie man den Beispielen in der Tabelle 1 entnehmen kann, zeigen die erfindungsgemäßen Elektrolumineszenzvorrichtungen höhere Effizienz und längere Lebensdauer bei vergleichbaren Farbkoordinaten im Vergleich zu Elektrolumineszenzvorrichtungen gemäß dem Stand der Technik.

**Tabelle 1**

| **Beispiel** | **HTL1** | **HTL2** | **EML** | **Max Effizienz (cd/A)** | **Spannung (V) bei 100cd/m²** | **CIE** | **Lebensdauer (h)** |
|---|---|---|---|---|---|---|---|
| Beispiel 2 | **HTM-1** | **NPB** | **H1** : **D1** (3%) | 11.8 | 5.5 | x=0.17; y=0.32 | 6700 |
| | (10 nm) | (30 nm) | (30 nm) | | | | |
| Beispiel 3 | **HTM-1** | **NPB** | **H1** : **D1** (5%) | 12.2 | 5.3 | x=0.17; y=0.33 | 7000 |
| | (10 nm) | (30 nm) | (30 nm) | | | | |
| Beispiel 4 | **HTM-1** | **NPB** | **H1** : **D1** (7%) | 11.5 | 5.2 | x=0.18; y=0.36 | 5300 |
| | (10 nm) | (30 nm) | (30 nm) | | | | |
| Beispiel 5 | **HTM-1** | **NPB** | **H2** : **D1** (5%) | 11.9 | 5.4 | x=0.17; y=0.33 | 2300 |
| | (10 nm) | (30 nm) | (30 nm) | | | | |
| Beispiel 6 | **HTM-1** | **NPB** | **H3** : **D1** (5%) | 5.9 | 5.8 | x=0.18; y=0.31 | 650 |
| (Vergleich) | (10 nm) | (20 nm) | (30 nm) | | | | |
| Beispiel 7 | **HTM-1** | **NPB** | **H4** : **D1** (5%) | 5.4 | 6.5 | x=0.19; y=0.37 | 350 |
| (Vergleich) | (10 nm) | (30 nm) | (30 nm) | | | | |
| Beispiel 8 | **HTM-1** | **NPB** | **H5** | 4.2 | 5.8 | x=0.17; y=0.26 | 400 |
| (Vergleich) | (10 nm) | (30 nm) | (30 nm) | | | | |
| Beispiel 9 | **HTM-1** | **NPB** | **H5 : D1** (5%) | 4.9 | 6.3 | x=0.17; y=0.31 | 300 |
| (Vergleich) | (10 nm) | (30 nm) | (30 nm) | | | | |

## Patentansprüche

1. Organische Elektrolumineszenzvorrichtungen, enthaltend Anode, Kathode und mindestens eine organische Schicht, **dadurch gekennzeichnet, dass** die organische Schicht die folgenden Komponenten enthält:
a) mindestens eine Verbindung der Formel (1), 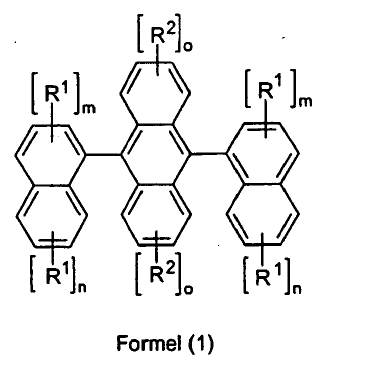 wobei für die verwendeten Symbole gilt:
R¹ ist gleich oder verschieden bei jedem Auftreten F, Cl, Br, I, CN, eine geradkettige Alkyl-, Alkoxy- oder Thioalkoxy- gruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch -R³C=CR³-, -C≡C-, Si(R³)₂, Ge(R³)₂, Sn(R³)₂, C=O, C=S, C=Se, C=NR², -O-, -S-, -N(R³)- oder -CONR³- ersetzt sein können und wobei ein oder mehrere H-Atome durch F, Cl, Br, I, CN oder NO₂ ersetzt sein können, oder eine Aralkylgruppe mit 7 bis 30 C-Atomen, die mit einem oder mehreren Resten R³ substituiert sein kann, oder eine Aryloxy- oder Heteroaryl- oxygruppe mit 5 bis 24 aromatischen Ringatomen, die durch einen oder mehrere nicht-aromatische Reste R³ substituiert sein kann; dabei können auch zwei oder mehrere Substituenten R¹ miteinander ein mono- oder polycyclisches, aliphatisches Ringsystem bilden;
R² ist bei jedem Auftreten gleich oder verschieden R¹ oder ein aromatisches oder heteroaromatisches Ringsystem mit 5 bis 30 aromatischen Ringatomen, welches mit einem oder mehreren Resten R³ substituiert sein kann;
R³ ist bei jedem Auftreten gleich oder verschieden H oder ein aliphatischer oder aromatischer Kohlenwasserstoffrest mit 1 bis 20 C-Atomen; dabei können auch zwei oder mehrere Reste R³ miteinander ein mono- oder polycyclisches, aliphatisches oder aromatisches Ringsystem bilden;
m ist gleich oder verschieden bei jedem Auftreten 0, 1, 2 oder 3;
n, o ist gleich oder verschieden bei jedem Auftreten 0; 1, 2, 3 oder 4;
und
b) mindestens eine Verbindung der Formel (2), 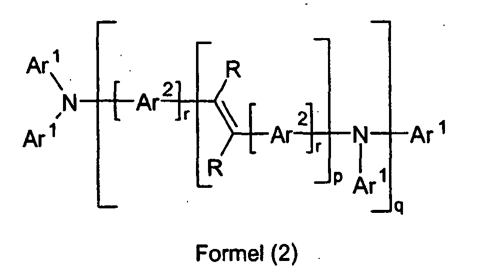 wobei für die verwendeten Symbole gilt:
Ar¹ ist gleich oder verschieden bei jedem Auftreten ein aromatisches oder heteroaromatisches Ringsystem mit 5 bis 30 aromatischen Ringatomen, welches durch einen oder mehrere Reste R⁴ substituiert sein kann;
Ar² ist gleich oder verschieden bei jedem Auftreten eine Arylen- oder Heteroarylengruppe mit 5 bis 20 aromatischen Ringatomen, welche durch einen oder mehrere Reste R⁴ substituiert sein kann;
R ist gleich oder verschieden bei jedem Auftreten H, F, CN, eine geradkettige Alkylgruppe mit 1 bis 40 C-Atomen oder eine verzweigte oder cyclische Alkylkette mit 3 bis 40 C-Atomen, die jeweils mit einem oder mehreren Resten R⁵ substituiert sein kann, wobei eine oder mehrere nicht benachbarte CH₂-Gruppen, die nicht direkt an die Doppel- bindung binden, durch -R⁵C=CR⁵-, -C≡C-, Si(R⁵)₂, Ge(R⁵)₂, Sn(R⁵)₂, C=O, C=S, C=Se, C=NR⁵, -O-, -S-, -N(R⁵)- oder -CONR⁵- ersetzt sein können und wobei ein oder mehrere H-Atome durch F, Cl, Br, I, CN oder NO₂ ersetzt sein können, oder eine Aryl- oder Heteroarylgruppe mit 5 bis 30 aromatischen Ringatomen, die wiederum mit einem oder mehreren Resten R⁵ oder mit einer Diphenylaminogruppe, wobei die Phenylgruppen durch nicht-aromatische Reste R substituiert sein können, substituiert sein kann;
R⁴ ist gleich oder verschieden bei jedem Auftreten H, F, Cl, Br, I, CN, Si(R⁵)₃, N(R⁵)₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxy- gruppe mit 3 bis 40 C-Atomen, die jeweils mit einem oder mehreren Resten R⁵ substituiert sein kann, wobei eine oder mehrere nicht benachbarte CH₂-Gruppen durch -R⁵C=CR⁵-, -C≡C-, Si(R⁵)₂, Ge(R⁵)₂, Sn(R⁵)₂, C=O, C=S, C=Se, C=NR⁵, -O-, -S-, -N(R⁵)- oder -CONR⁵- ersetzt sein können und wobei ein oder mehrere H-Atome durch F, Cl, Br, I; CN oder NO₂ ersetzt sein können, oder eine Aryl- oder Heteroarylgruppe mit 5 bis 30 aromatischen Ringatomen, die mit einem oder mehreren nicht- aromatischen Resten R⁵ substituiert sein kann, oder eine Aryloxy- oder Heteroaryloxygruppe mit 5 bis 24 aromatischen Ringatomen, die durch einen oder mehrere nicht-aromatische Reste R⁴ substituiert sein kann; dabei können auch zwei oder mehrere Substituenten R⁴ miteinander, auch an verschiedenen Gruppen Ar¹ bzw. Ar², ein mono- oder polycyclisches, aliphatisches oder aromatisches Ringsystem bilden;
R⁵ ist bei jedem Auftreten gleich oder verschieden H oder ein aliphatischer oder aromatischer Kohlenwasserstoffrest mit 1 bis 20 C-Atomen; dabei können auch zwei oder mehrere . Reste R⁵ miteinander ein mono- oder polycyclisches, aliphatisches oder aromatisches Ringsystem bilden;
p, r ist gleich oder verschieden bei jedem Auftreten 1, 2 oder 3;
q ist 1, 2 oder 3;

2. Organische Elektrolumineszenzvorrichtung nach Anspruch 1, **dadurch gekennzeichnet, dass** das Symbol R¹ in Formel (1) gleich oder verschieden bei jedem Auftreten, für F, eine geradkettige Alkyl- oder Alkoxygruppe mit 1 bis 6 C-Atomen oder eine verzweigte oder cyclische Alkyl- oder Alkoxygruppe mit 3 bis 10 C-Atomen, wobei jeweils ein oder mehrere CH₂-Gruppen durch -R³C=CR³-, Si(R³)₂, -O-, -S- oder -N(R³)- ersetzt sein können und wobei jeweils ein oder mehrere H-Atome durch F ersetzt sein können, steht; dabei können auch zwei oder mehrere Reste R¹ miteinander ein mono- oder polycyclisches, aliphatisches Ringsystem bilden.

3. Organische Elektrolumineszenzvorrichtung nach Anspruch 1 oder 2, **dadurch gekennzeichnet, dass** das Symbol R² in Formel (1) für ein aromatisches oder heteroaromatisches Ringsystem mit 5 bis 16 aromatischen Ringatomen, welches durch einen oder mehrere Reste R³ substituiert sein kann, steht.

4. Organische Elektrolumineszenzvorrichtung nach einem oder mehreren der Ansprüche 1 bis 3, **dadurch gekennzeichnet, dass** die Verbindungen gemäß Formel (1) reine Kohlenwasserstoffverbindungen sind.

5. Organische Elektrolumineszenzvorrichtung nach einem oder mehreren der Ansprüche 1 bis 4, **dadurch gekennzeichnet, dass** das Symbol Ar¹ in Verbindungen der Formel (2) gleich oder verschieden bei jedem Auftreten für eine Aryl-, Biaryl- oder Heteroarylgruppe, insbesondere eine Aryl- oder Biarylgruppe, mit 6 bis 14 C-Atomen steht, welche durch einen oder mehrere Reste R⁴ substituiert sein kann.

6. Organische Elektrolumineszenzvorrichtung nach einem oder mehreren der Ansprüche 1 bis 5, **dadurch gekennzeichnet, dass** das Symbol Ar² gleich oder verschieden bei jedem Auftreten für eine Arylen- oder Heteroarylengruppe, insbesondere eine Arylengruppe, mit 5 bis 14 aromatischen Ringatomen steht, welche mit einem oder mehreren Resten R⁴ substituiert sein kann.

7. Organische Elektrolumineszenzvorrichtung nach einem oder mehreren der Ansprüche 1 bis 6, **dadurch gekennzeichnet, dass** der Rest R, gleich oder verschieden bei jedem Auftreten, für H, eine geradkettige Alkylgruppe mit 1 bis 4 C-Atomen, eine verzweigte oder cyclische Alkylgruppe mit 3 bis 5 C-Atomen oder eine Phenyl- bzw. Naphthylgruppe, welche durch einen oder mehrere Reste R⁵ substituiert sein kann, steht.

8. Organische Elektrolumineszenzvorrichtung nach einem oder mehreren der Ansprüche 1 bis 7, **dadurch gekennzeichnet, dass** die Verbindungen der Formel (2) ausgewählt sind aus Verbindungen der Formel (2a), wobei die Phenyl- bzw. Phenylengruppen noch durch einen oder mehrere Reste R⁴ substituiert sein können:

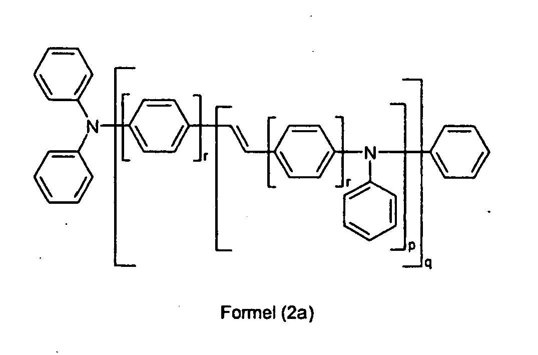

9. Organische Elektrolumineszenzvorrichtung nach einem oder mehreren der Ansprüche 1 bis 8, **dadurch gekennzeichnet, dass** die Reste R⁴ ausgewählt sind aus der Gruppe bestehend aus H, F, geradkettigen Alkyl- oder Alkoxygruppen mit 1 bis 6 C-Atomen oder verzweigten oder cyclischen Alkyl- oder Alkoxygruppen mit 3 bis 10 C-Atomen, die mit einem oder mehreren Resten R⁵ substituiert sein kann und wobei jeweils ein oder mehrere CH₂-Gruppen durch -R⁵C=CR⁵-, Si(R⁵)₂, -O-, -S- oder -N(R⁵)- ersetzt sein können und wobei jeweils ein oder mehrere H-Atome durch F ersetzt sein können, oder monovalenten Aryl- oder Heteroarylgruppen mit 5 bis 14 aromatischen Ringatomen; dabei können zwei oder mehrere Reste R⁴ auch miteinander ein Ringsystem bilden.

10. Organische Elektrolumineszenzvorrichtung nach einem oder mehreren der Ansprüche 1 bis 9, **dadurch gekennzeichnet, dass** außer Kathode, Anode und der emittierenden Schicht weitere Schichten enthalten sind, ausgewählt aus Lochinjektionsschicht, Lochtransportschicht, Elektronentransportschicht und/oder Elektroneninjektionsschicht, und dass sie gegebenenfalls mehrere emittierende Schichten enthält und so zur Emission von weißem Licht befähigt ist.

11. Verfahren zur Herstellung organischer Elektrolumineszenzvorrichtungen nach einem oder mehreren der Ansprüche 1 bis 10, **dadurch gekennzeichnet, dass** mindestens eine Verbindung gemäß Formel (1) zusammen mit mindestens einer Verbindung gemäß Formel (2) durch ein Sublimationsverfahren oder aus Lösung, beispielsweise durch ein Druckverfahren, aufgebracht werden.

12. Mischungen enthaltend mindestens eine Verbindung gemäß Formel (1) gemäß Anspruch 1 und mindestens eine Verbindung gemäß Formel (2) gemäß Anspruch 1.

13. Verwendung von Mischungen gemäß Anspruch 12 zur Herstellung organischer elektronischer Vorrichtungen, insbesondere organischer Elektrolumineszenzvorrichtungen.

## Claims

1. Organic electroluminescent devices containing anode, cathode and at least one organic layer, **characterised in that** the organic layer comprises the following components:
a) at least one compound of the formula (1) 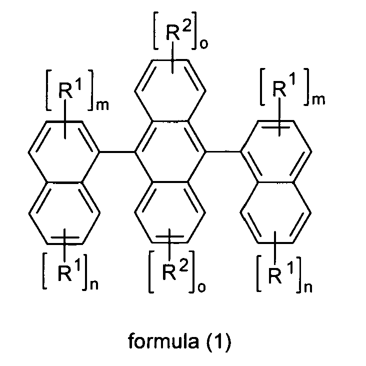 where the following applies to the symbols used:
R¹ is, identically or differently on each occurrence, F, Cl, Br, I, CN, a straight-chain alkyl, alkoxy or thioalkoxy group hav- ing 1 to 40 C atoms or a branched or cyclic alkyl, alkoxy or thioalkoxy group having 3 to 40 C atoms, each of which may be substituted by one or more radicals R³, where one or more non-adjacent CH₂ groups may be replaced by -R³C=CR³-, -C≡C-, Si(R³)₂, Ge(R³)₂, Sn(R³)₂, C=O, C=S, C=Se, C=NR², -O-, -S-, -N(R³)- or -CONR³- and where one or more H atoms may be replaced by F, Cl, Br, I, CN or NO₂, or an aralkyl group having 7 to 30 C atoms, which may be substituted by one or more radicals R³, or an aryl- oxy or heteroaryloxy group having 5 to 24 aromatic ring atoms, which may be substituted by one or more non- aromatic radicals R³; two or more substituents R¹ here may also form a mono- or polycyclic, aliphatic ring system with one another;
R² is on each occurrence, identically or differently, R¹ or an aromatic or heteroaromatic ring system having 5 to 30 aromatic ring atoms, which may be substituted by one or more radicals R³;
R³ is on each occurrence, identically or differently, H or an ali- phatic or aromatic hydrocarbon radical having 1 to 20 C atoms; two or more radicals R³ here may also form a mono- or polycyclic, aliphatic or aromatic ring system with one another;
m is, identically or differently on each occurrence, 0, 1, 2 or 3;
n, o are, identically or differently on each occurrence, 0, 1, 2, 3 or 4;
and
b) at least one compound of the formula (2) 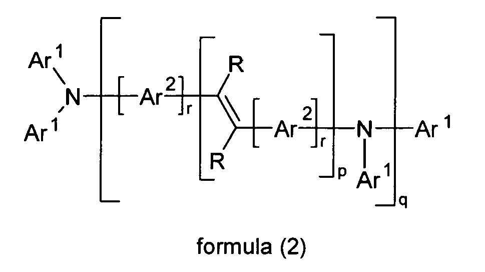 where the following applies to the symbols used:
Ar¹ is, identically or differently on each occurrence, an aroma- tic or heteroaromatic ring system having 5 to 30 aromatic ring atoms, which may be substituted by one or more radi- cals R⁴;
Ar² is, identically or differently on each occurrence, an arylene or heteroarylene group having 5 to 20 aromatic ring atoms, which may be substituted by one or more radicals R⁴;
R is, identically or differently on each occurrence, H, F, CN, a straight-chain alkyl group having 1 to 40 C atoms or a branched or cyclic alkyl chain having 3 to 40 C atoms, each of which may be substituted by one or more radicals R⁵, where one or more non-adjacent CH₂ groups which are not bonded directly to the double bond may be replaced by -R⁵C=CR⁵-, -C≡C-, Si(R⁵)₂, Ge(R⁵)₂, Sn(R⁵)₂, C=O, C=S, C=Se, C=NR⁵, -O-, -S-, -N(R⁵)- or -CONR⁵- and where one or more H atoms may be replaced by F, Cl, Br, I, CN or NO₂, or an aryl or heteroaryl group having 5 to 30 aromatic ring atoms, which may in turn be substituted by one or more radicals R⁵ or by a diphenylamino group, where the phenyl groups may be substituted by non-aromatic radicals R;
R⁴ is, identically or differently on each occurrence, H, F, Cl, Br, I, CN, Si(R⁵)₃, N(R⁵)₂, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals R⁵, where one or more non-adjacent CH₂ groups may be replaced by -R⁵C=CR⁵-, -C≡C-, Si(R⁵)₂, Ge(R⁵)₂, Sn(R⁵)₂, C=O, C=S, C=Se, C=NR⁵, -O-, -S-, -N(R⁵)- or -CONR⁵- and where one or more H atoms may be re- placed by F, Cl, Br, I, CN or NO₂, or an aryl or heteroaryl group having 5 to 30 aromatic ring atoms, which may be substituted by one or more non-aromatic radicals R⁵, or an aryloxy or heteroaryloxy group having 5 to 24 aromatic ring atoms, which may be substituted by one or more non- aromatic radicals R⁴; two or more substituents R⁴ here may also form a mono- or polycyclic, aliphatic or aromatic ring system with one another, also on different groups Ar¹ or Ar²;
R⁵ is on each occurrence, identically or differently, H or an ali- phatic or aromatic hydrocarbon radical having 1 to 20 C atoms; two or more radicals R⁵ here may also form a mono- or polycyclic, aliphatic or aromatic ring system with one another;
p, r are, identically or differently on each occurrence, 1, 2 or 3;
q is 1, 2 or 3.

2. Organic electroluminescent device according to Claim 1, **characterised in that** the symbol R¹ in formula (1), identically or differently on each occurrence, stands for F, a straight-chain alkyl or alkoxy group having 1 to 6 C atoms or a branched or cyclic alkyl or alkoxy group having 3 to 10 C atoms, where in each case one or more CH₂ groups may be replaced by -R³C=CR³-, Si(R³)₂, -O-, -S- or -N(R³)- and where in each case one or more H atoms may be replaced by F; two or more radicals R¹ here may also form a mono- or polycyclic, aliphatic ring system with one another.

3. Organic electroluminescent device according to Claim 1 or 2, **characterised in that** the symbol R² in formula (1) stands for an aromatic or heteroaromatic ring system having 5 to 16 aromatic ring atoms, which may be substituted by one or more radicals R³.

4. Organic electroluminescent device according to one or more of Claims 1 to 3, **characterised in that** the compounds of the formula (1) are pure hydrocarbon compounds.

5. Organic electroluminescent device according to one or more of Claims 1 to 4, **characterised in that** the symbol Ar¹ in compounds of the formula (2), identically or differently on each occurrence, stands for an aryl, biaryl or heteroaryl group, in particular an aryl or biaryl group, having 6 to 14 C atoms, which may be substituted by one or more radicals R⁴.

6. Organic electroluminescent device according to one or more of Claims 1 to 5, **characterised in that** the symbol Ar², identically or differently on each occurrence, stands for an arylene or heteroarylene group, in particular an arylene group, having 5 to 14 aromatic ring atoms, which may be substituted by one or more radicals R⁴.

7. Organic electroluminescent device according to one or more of Claims 1 to 6, **characterised in that** the radical R, identically or differently on each occurrence, stands for H, a straight-chain alkyl group having 1 to 4 C atoms, a branched or cyclic alkyl group having 3 to 5 C atoms or a phenyl or naphthyl group, each of which may be substituted by one or more radicals R⁵.

8. Organic electroluminescent device according to one or more of Claims 1 to 7, **characterised in that** the compounds of the formula (2) are selected from compounds of the formula (2a), where the phenyl or phenylene groups may also be substituted by one or more radicals R⁴:

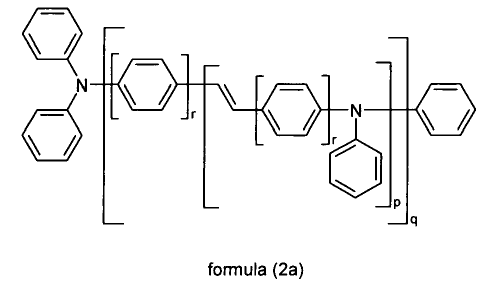

9. Organic electroluminescent device according to one or more of Claims 1 to 8, **characterised in that** the radicals R⁴ are selected from the group consisting of H, F, straight-chain alkyl or alkoxy groups having 1 to 6 C atoms or branched or cyclic alkyl or alkoxy groups having 3 to 10 C atoms, each of which may be substituted by one or more radicals R⁵ and where in each case one or more CH₂ groups may be replaced by -R⁵C=CR⁵-, Si(R⁵)₂, -O-, -S- or -N(R⁵)- and where in each case one or more H atoms may be replaced by F, or monovalent aryl or heteroaryl groups having 5 to 14 aromatic ring atoms; two or more radicals R⁴ here may also form a ring system with one another.

10. Organic electroluminescent device according to one or more of Claims 1 to 9, **characterised in that**, apart from cathode, anode and the emitting layer, further layers are present selected from hole-injection layer, hole-transport layer, electron-transport layer and/or electron-injection layer, and that it optionally comprises a plurality of emitting layers and is thus capable of the emission of white light.

11. Process for the production of organic electroluminescent devices according to one or more of Claims 1 to 10, **characterised in that** at least one compound of the formula (1) is applied together with at least one compound of the formula (2) by a sublimation method or from solution, for example by a printing process.

12. Mixtures comprising at least one compound of the formula (1) according to Claim 1 and at least one compound of the formula (2) according to Claim 1.

13. Use of mixtures according to Claim 12 for the production of organic electronic devices, in particular organic electroluminescent devices.

## Revendications

1. Dispositifs électroluminescents organiques contenant une anode, une cathode et au moins une couche organique, **caractérisés en ce que** la couche organique comprend les composants suivants :
a) au moins un composé de formule (1) 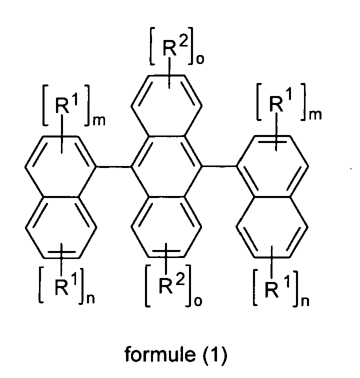 où ce qui suit s'applique aux symboles utilisés :
R¹ est, de manière identique ou différente à chaque occur- rence, F, Cl, Br, I, CN, un groupement alkyle, alcoxy ou thioalcoxy à chaîne linéaire ayant de 1 à 40 atomes de C ou un groupement alkyle, alcoxy ou thioalcoxy ramifié ou cyclique ayant de 3 à 40 atomes de C, chacun d'entre eux pouvant être substitué par un ou plusieurs radicaux R³, où un ou plusieurs groupements CH₂ non adjacents peuvent être remplacés par -R³C=CR³-, -C≡C-, Si(R³)₂, Ge(R³)₂, Sn(R³)₂, C=O, C=S, C=Se, C=NR², -O-, -S-, -N(R³)- ou -CONR³- et où un ou plusieurs atomes de H peuvent être remplacés par F, Cl, Br, l, CN ou NO₂, ou un groupement aralkyle ayant de 7 à 30 atomes de C, pouvant être subs- titué par un ou plusieurs radicaux R³, ou un groupement aryloxy ou hétéroaryloxy ayant de 5 à 24 atomes de cycle aromatique, pouvant être substitué par un ou plusieurs radicaux R³ non aromatiques ; deux substituants R¹, ou plus, peuvent ici aussi former un noyau aliphatique mono- ou polycyclique les uns avec les autres ;
R² est à chaque occurrence, de manière identique ou diffé- rente, R¹ ou un noyau aromatique ou hétéroaromatique ayant de 5 à 30 atomes de cycle aromatique, pouvant être substitué par un ou plusieurs radicaux R³ ;
R³ est à chaque occurrence, de manière identique ou diffé- rente, H ou un radical hydrocarboné aliphatique ou aroma- tique ayant de 1 à 20 atomes de C ; deux radicaux R³, ou plus, peuvent ici aussi former un noyau aliphatique ou aromatique mono- ou polycyclique les uns avec les autres ;
m est, de manière identique ou différente à chaque occur- rence, 0, 1, 2 ou 3 ;
n, o sont, de manière identique ou différente à chaque occur- rence, 0, 1, 2, 3 ou 4 ;
et
b) au moins un composé de formule (2) 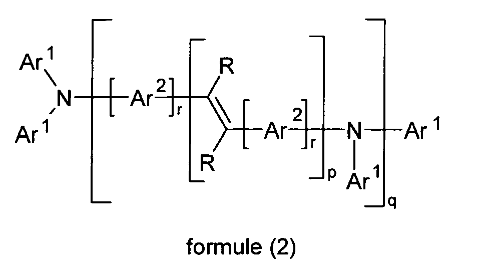 où ce qui suit s'applique aux symboles utilisés :
Ar¹ est, de manière identique ou différente à chaque occur- rence, un noyau aromatique ou hétéroaromatique ayant de 5 à 30 atomes de cycle aromatique, pouvant être substitué par un ou plusieurs radicaux R⁴ ;
Ar² est, de manière identique ou différente à chaque occur- rence, un groupement arylène ou hétéroarylène ayant de 5 à 20 atomes de cycle aromatique, pouvant être substitué par un ou plusieurs radicaux R⁴ ;
R est, de manière identique ou différente à chaque occur- rence, H, F, CN, un groupement alkyle à chaîne linéaire ayant de 1 à 40 atomes de C ou une chaîne alkyle rami- fiée ou cyclique ayant de 3 à 40 atomes de C, chacun d'entre eux pouvant être substitué par un ou plusieurs radicaux R⁵, où un ou plusieurs groupements CH₂ non adjacents n'étant pas liés directement à la double liaison peuvent être remplacés par -R⁵C=CR⁵-, -C≡C-, Si(R⁵)₂, Ge(R⁵)₂, Sn(R⁵)₂, C=O, C=S, C=Se, C=NR⁵, -O-, -S-, -N(R⁵)- ou -CONR⁵- et où un ou plusieurs atomes de H peuvent être remplacés par F, Cl, Br, I, CN ou NO₂, ou un groupement aryle ou hétéroaryle ayant de 5 à 30 atomes de cycle aromatique, pouvant être à son tour substitué par un ou plusieurs radicaux R⁵ ou par un groupement di- phénylamino, où les groupements phényle peuvent être substitués par des radicaux R non aromatiques ;
R⁴ est, de manière identique ou différente à chaque occur- rence, H, F, Cl, Br, I, CN, Si(R⁵)₃, N(R⁵)₂, un groupement alkyle, alcoxy ou thioalcoxy à chaîne linéaire ayant de 1 à 40 atomes de C ou un groupement alkyle, alcoxy ou thioalcoxy ramifié ou cyclique ayant de 3 à 40 atomes de C, chacun d'entre eux pouvant être substitué par un ou plusieurs radicaux R⁵, où un ou plusieurs groupements CH₂ non adjacents peuvent être remplacés par -R⁵C=CR⁵-, -C≡C-, Si(R⁵)₂, Ge(R⁵)₂, Sn(R⁵)₂, C=O, C=S, C=Se, C=NR⁵, -O-, -S-, -N(R⁵)- ou -CONR⁵- et où un ou plusieurs atomes de H peuvent être remplacés par F, Cl, Br, I, CN ou NO₂, ou un groupement aryle ou hétéroaryle ayant de 5 à 30 atomes de cycle aromatique, pouvant être substitué par un ou plusieurs radicaux R⁵ non aromati- ques, ou un groupement aryloxy ou hétéroaryloxy ayant de 5 à 24 atomes de cycle aromatique, pouvant être substitué par un ou plusieurs radicaux R⁴ non aromatiques ; deux substituants R⁴, ou plus, peuvent ici aussi former un noyau aliphatique ou aromatique mono- ou polycyclique les uns avec les autres, de même sur différents groupements Ar¹ ou Ar²;
R⁵ est à chaque occurrence, de manière identique ou diffé- rente, H ou un radical hydrocarboné aliphatique ou aroma- tique ayant de 1 à 20 atomes de C ; deux radicaux R⁵, ou plus, peuvent ici aussi former un noyau aliphatique ou aromatique mono- ou polycyclique les uns avec les autres ;
p, r sont, de manière identique ou différente à chaque occur- rence, 1, 2 ou 3 ;
q vaut 1, 2 ou 3.

2. Dispositif électroluminescent organique selon la revendication 1, **caractérisé en ce que** le symbole R¹ dans la formule (1), de manière identique ou différente à chaque occurrence, représente F, un groupement alkyle ou alcoxy à chaîne linéaire ayant de 1 à 6 atomes de C ou un groupement alkyle ou alcoxy ramifié ou cyclique ayant de 3 à 10 atomes de C, où dans chaque cas un ou plusieurs groupements CH₂ peuvent être remplacés par -R³C=CR³-, Si(R³)₂, -O-, -S- ou -N(R³)- et où dans chaque cas un ou plusieurs atomes de H peuvent être remplacés par F ; deux radicaux R¹, ou plus, peuvent ici aussi former un noyau aliphatique mono- ou polycyclique les uns avec les autres.

3. Dispositif électroluminescent organique selon la revendication 1 ou 2, **caractérisé en ce que** le symbole R² dans la formule (1) représente un noyau aromatique ou hétéroaromatique ayant de 5 à 16 atomes de cycle aromatique, pouvant être substitué par un ou plusieurs radicaux R³.

4. Dispositif électroluminescent organique selon l'une ou plusieurs des revendications 1 à 3, **caractérisé en ce que** les composés de formule (1) sont des composés hydrocarbonés purs.

5. Dispositif électroluminescent organique selon l'une ou plusieurs des revendications 1 à 4, **caractérisé en ce que** le symbole Ar¹ dans les composés de formule (2), de manière identique ou différente à chaque occurrence, représente un groupement aryle, biaryle ou hétéroaryle, en particulier un groupement aryle ou biaryle, ayant de 6 à 14 atomes de C, pouvant être substitué par un ou plusieurs radicaux R⁴.

6. Dispositif électroluminescent organique selon l'une ou plusieurs des revendications 1 à 5, **caractérisé en ce que** le symbole Ar², de manière identique ou différente à chaque occurrence, représente un groupement arylène ou hétéroarylène, en particulier un groupement arylène, ayant de 5 à 14 atomes de cycle aromatique, pouvant être substitué par un ou plusieurs radicaux R⁴.

7. Dispositif électroluminescent organique selon l'une ou plusieurs des revendications 1 à 6, **caractérisé en ce que** le radical R, de manière identique ou différente à chaque occurrence, représente H, un groupement alkyle à chaîne linéaire ayant de 1 à 4 atomes de C, un groupement alkyle ramifié ou cyclique ayant de 3 à 5 atomes de C ou un groupement phényle ou naphtyle, chacun d'entre eux pouvant être substitué par un ou plusieurs radicaux R⁵.

8. Dispositif électroluminescent organique selon l'une ou plusieurs des revendications 1 à 7, **caractérisé en ce que** les composés de formule (2) sont choisis parmi les composés de formule (2a), ou les groupements phényle ou phénylène peuvent également être substitués par un ou plusieurs radicaux R⁴ :

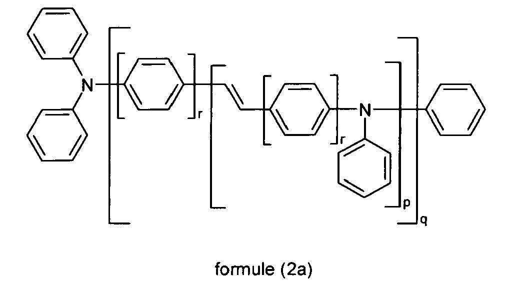

9. Dispositif électroluminescent organique selon l'une ou plusieurs des revendications 1 à 8, **caractérisé en ce que** les radicaux R⁴ sont choisis parmi le groupe constitué par H, F, des groupements alkyle ou alcoxy à chaîne linéaire ayant de 1 à 6 atomes de C ou des groupements alkyle ou alcoxy ramifiés ou cycliques ayant de 3 à 10 atomes de C, chacun d'entre eux pouvant être substitué par un ou plusieurs radicaux R⁵ et où dans chaque cas un ou plusieurs groupements CH₂ peuvent être remplacés par -R⁵C=CR⁵-, Si(R⁵)₂, -O-, -Sou -N(R⁵)- et où dans chaque cas un ou plusieurs atomes de H peuvent être remplacés par F, ou des groupements aryle ou hétéroaryle monovalents ayant de 5 à 14 atomes de cycle aromatique ; deux radicaux R⁴, ou plus, peuvent ici aussi former un noyau les uns avec les autres.

10. Dispositif électroluminescent organique selon l'une ou plusieurs des revendications 1 à 9, **caractérisé en ce que**, outre la cathode, l'anode et la couche émettrice, des couches supplémentaires choisies parmi une couche d'injection de trous, une couche de transport de trous, une couche de transport d'électrons et/ou une couche d'injection d'électrons, sont présentes, et qu'il comprend éventuellement une pluralité de couches émettrices et est donc capable d'émettre de la lumière blanche.

11. Procédé de production de dispositifs électroluminescents organiques selon l'une ou plusieurs des revendications 1 à 10, **caractérisé en ce qu'**au moins un composé de formule (1) est appliqué conjointement avec au moins un composé de formule (2) par une méthode de sublimation ou à partir d'une solution, par exemple par un procédé d'impression.

12. Mélanges comprenant au moins un composé de formule (1) selon la revendication 1 et au moins un composé de formule (2) selon la revendication 1.

13. Utilisation de mélanges selon la revendication 12 pour la production de dispositifs électroniques organiques, en particulier de dispositifs électroluminescents organiques.
